# EUROPÄISCHE PATENTSCHRIFT

(11) **EP 2 619 859 B1**
(45) Veröffentlichungstag und Bekanntmachung des Hinweises auf die Patenterteilung: **13.05.2020**
(21) Anmeldenummer: 11755076.4
(22) Anmeldetag: 13.09.2011
(51) Int. Cl.: H01S 5/022, H01S 5/024, H01L 33/48, H01L 33/62, H01L 33/64

(54) **GEHÄUSE FÜR EIN OPTOELEKTRONISCHES HALBLEITERBAUELEMENT**
HOUSING FOR AN OPTOELECTRONIC SEMICONDUCTOR COMPONENT
BOÎTIER POUR COMPOSANT SEMI-CONDUCTEUR OPTOÉLECTRONIQUE

(30) Priorität: 20.09.2010 DE 102010046090
(43) Veröffentlichungstag der Anmeldung: 31.07.2013
(60) Teilanmeldung: 20163678.4
(73) Patentinhaber: OSRAM Opto Semiconductors GmbH, 93055 Regensburg (DE)
(72) Erfinder: MÖLLMER, Frank, 93080 Matting bei Pentling (DE); ARZBERGER, Markus, 93055 Regensburg (DE); SCHWIND, Michael, 93161 Sinzing (DE); HÖFER, Thomas, 93138 Lappersdorf (DE)
(74) Vertreter: Epping - Hermann - Fischer
(86) Internationale Anmeldenummer: PCT/EP2011/065847
(87) Internationale Veröffentlichungsnummer: WO 2012/038304

(56) Entgegenhaltungen:
- EP-A2- 0 607 700
- DE-A1- 10 260 432
- US-A- 5 825 054
- US-A1- 2005 072 985
- US-A1- 2005 194 601
- US-A1- 2007 228 535
- US-A1- 2009 103 581

## Beschreibung

Gehäuse für ein optoelektronisches Halbleiterbauelement und Halbleiterbauelement

Die vorliegende Anmeldung betrifft ein Gehäuse für ein optoelektronisches Halbleiterbauelement sowie ein Halbleiterbauelement mit einem solchen Gehäuse.

Diese Patentanmeldung beansprucht die Priorität der deutschen Patentanmeldung 10 2010 046 090.7.

Die Druckschrift US 5825054 A beschreibt ein Gehäuse für einen Halbleiterlaser.

Die Druckschrift US 2005/072985 A1 beschreibt einen Halbleiterlaser mit einem Laserchip, mehreren Leitern und einem Körper aus einem Vergussharz.

Die Druckschrift US 2007/228535 A1 beschreibt ein Gehäuse für ein optisches Bauteil.

Die Druckschrift EP 0607700 A2 beschreibt ein Laserbauteil mit einem Leadframe und einem Befestigungselement.

Die Druckschrift DE 10260432 A1 beschreibt eine LED mit Halbleiterchips, die auf einem Substrat befestigt sind und über elektrische Leitungen kontaktierbar sind.

Die Druckschrift US 2009/103581 A1 beschreibt einen Halbleiterlaser mit einer Laserdiode, welche auf einer

Wärmesenke angebracht ist und welche mittels Leitern elektrisch kontaktiert wird.

Die Druckschrift US 2005/0194601 A1 beschreibt ein lichtemittierendes Bauteil mit einem lichtemittierenden Element und einem Metallgehäuse. In dem Metallgehäuse sind Öffnungen, durch welche über Elektrodenpins das lichtemittierende Element kontaktierbar ist.

Für Halbleiterlaserdioden mit Abwärmeleistungen bis in den Watt-Bereich finden oftmals so genannte TO-Gehäuse, beispielsweise T056-, T038- oder T09-Gehäuse Anwendung. Aufgrund des vergleichsweise komplizierten Aufbaus dieser Metallgehäuse sind diese jedoch für Anwendungen im Consumer-Markt zu kostenintensiv.

Eine Aufgabe ist es ein Gehäuse für ein optoelektronisches Halbleiterbauelement anzugeben, das einfach und kostengünstig herstellbar ist und gleichzeitig eine gute Wärmeabfuhr aus dem Halbleiterbauelement, sowie gute Montagefähigkeit gewährleistet.

Diese Aufgabe wird durch den Gegenstand des Patentanspruchs 1 gelöst. Ausgestaltungen und Weiterbildungen sind Gegenstand der abhängigen Patentansprüche.

Ein Gehäuse für ein optoelektronisches Halbleiterbauelement weist gemäß einer Ausführungsform einen Gehäusekörper, einen ersten Anschlussleiter und einen zweiten Anschlussleiter auf. Der erste Anschlussleiter und der zweite Anschlussleiter erstrecken sich in vertikaler Richtung jeweils durch den Gehäusekörper hindurch.

Der erste Anschlussleiter und der zweite Anschlussleiter ragen somit jeweils aus zwei gegenüberliegenden Seiten des Gehäusekörpers heraus. Somit können die Anschlussleiter jeweils auf der einen Seite des Gehäusekörpers für die elektrische Kontaktierung eines optoelektronischen Halbleiterchips und auf der gegenüberliegenden Seite des Gehäusekörpers der externen elektrischen Kontaktierung des Halbleiterbauelements dienen. Der erste Anschlussleiter ist vorzugsweise für die Befestigung des Halbleiterchips vorgesehen.

In einer bevorzugten Ausgestaltung ist der Gehäusekörper ein Kunststoffkörper, der an den ersten Anschlussleiter und an den zweiten Anschlussleiter angeformt ist. Ein solcher Gehäusekörper ist mittels eines Gießverfahrens besonders einfach und kostengünstig herstellbar. Unter einem Gießverfahren wird allgemein ein Verfahren verstanden, mit dem eine Formmasse gemäß einer vorgegebenen Form ausgestaltet werden kann, beispielsweise mittels Gießens, Spritzgießens (injection molding) oder Spritzpressens (transfer molding).

Unter einer vertikalen Richtung wird im Zweifel insbesondere eine Richtung verstanden, die senkrecht zu einer Haupterstreckungsebene des Gehäusekörpers verläuft. Vorzugsweise verläuft zumindest eine der Hauptflächen des Gehäusekörpers parallel zur Haupterstreckungsebene des Gehäusekörpers.

In einer bevorzugten Ausgestaltung sind der erste Anschlussleiter und der zweite Anschlussleiter in einer zur vertikalen Richtung senkrecht verlaufenden lateralen Richtung voneinander beabstandet. Die Anschlussleiter sind also lediglich über den Gehäusekörper mechanisch stabil miteinander verbunden. Weiterhin bevorzugt verlaufen der erste Anschlussleiter und der zweite Anschlussleiter parallel zueinander.

In einer weiteren bevorzugten Ausgestaltung ist eine entlang der vertikalen Richtung verlaufende Seitenfläche des ersten Anschlussleiters als eine Montagefläche für einen Halbleiterchip vorgesehen. Somit erfolgt die Abstrahlung eines Halbleiterchips, der als kantenemittierender Halbleiterlaserchip ausgebildet ist, in vertikaler Richtung.

In einer weiteren bevorzugten Ausgestaltung verlaufen der erste Anschlussleiter und der zweite Anschlussleiter in einer Ebene, die durch die vertikale Richtung und durch die laterale Richtung aufgespannt wird. Mit anderen Worten verlaufen die Ebene, in der die Anschlussleiter ausgebildet sind, und die Haupterstreckungsebene des Gehäusekörpers senkrecht zueinander.

Bei der Herstellung des Gehäuses können der erste Anschlussleiter und der zweite Anschlussleiter in einfacher Weise aus einem ebenen Metallblech hervorgehen. Das Metallblech kann beispielsweise Kupfer oder eine kupferhaltige Legierung enthalten oder aus einem solchen Material bestehen.

In einer bevorzugten Ausgestaltung ist der erste Anschlussleiter derart ausgebildet, dass die im Betrieb des Halbleiterbauelements im Halbleiterchip erzeugte Abwärme effizient über den ersten Anschlussleiter abgeführt werden kann.

Vorzugsweise weist der erste Anschlussleiter einen Querschnitt von mindestens 1 mm² auf. In einem Gehäuse mit einem derartigen ersten Anschlussleiter können auch Halbleiterchips montiert werden, die im Betrieb Abwärmeleistungen von 0,1 W oder mehr erzeugen.

Der erste Anschlussleiter kann also sowohl der elektrischen als auch der thermischen Kontaktierung des Halbleiterchips dienen. Ein separater Anschluss zur Wärmeabführung ist somit nicht erforderlich.

Weiterhin bevorzugt weist der erste Anschlussleiter an jeder Stelle entlang der vertikalen Richtung einen größeren Querschnitt auf als der zweite Anschlussleiter.

In einer bevorzugten Ausgestaltung weist das Gehäuse eine Kappe auf, die den ersten Anschlussleiter und den zweiten Anschlussleiter auf einer Seite des Gehäusekörpers umgibt. Mittels der Kappe kann der Halbleiterchip vor äußeren Einflüssen wie mechanischer Belastung oder Feuchtigkeit geschützt werden. Die Kappe ist vorzugsweise auf den Gehäusekörper steckbar ausgebildet. Nach der Montage des Halbleiterchips in dem Gehäuse kann die Kappe an dem Gehäusekörper befestigt werden. Die Verbindung mit dem Gehäusekörper kann je nach Anwendung dauerhaft oder lösbar, beispielsweise mittels einer Steckverbindung oder einer Rastverbindung, ausgebildet sein.

In einer bevorzugten Ausgestaltung ist in die Kappe ein optisches Element, beispielsweise eine Linse integriert. Die Kappe kann also gleichzeitig dem Schutz des Halbleiterchips vor mechanischer Belastung und der Strahlformung, insbesondere der Kollimation der abgestrahlten Strahlung, dienen.

Die Kappe weist vorzugsweise einen Deckel und einen den Deckel umlaufenden Mantel auf. Der Deckel ist zweckmäßigerweise für die von dem Halbleiterchip zu erzeugende Strahlung, beispielsweise Strahlung im ultravioletten, sichtbaren und/oder infraroten Spektralbereich durchlässig ausgebildet. Der Deckel kann das optische Element bilden.

In einer Ausgestaltungsvariante ist die Kappe einstückig ausgebildet und strahlungsdurchlässig.
In einer alternativen Ausgestaltungsvariante weisen der Deckel und der Mantel voneinander verschiedene Materialien auf. Der Mantel muss nicht notwendigerweise für die vom Halbleiterchip zu erzeugende Strahlung durchlässig ausgebildet sein.

Beispielsweise kann der Mantel ein Metall oder eine metallische Legierung enthalten oder aus einem solchen Material bestehen.

Mittels eines strahlungsundurchlässigen Mantels kann vermieden werden, dass ungewollt Strahlung in lateraler Richtung aus dem Halbleiterbauelement austritt.

Das Gehäuse kann auch mehr als zwei Anschlussleiter aufweisen. Beispielsweise kann ein weiterer Anschlussleiter für die elektrische Kontaktierung einer elektrischen Steuerschaltung vorgesehen sein.

Das beschriebene Gehäuse eignet sich insbesondere für ein Halbleiterbauelement, bei dem ein Halbleiterchip an dem ersten Anschlussleiter befestigt ist. Eine Hauptabstrahlrichtung des Halbleiterchips verläuft vorzugsweise entlang der vertikalen Richtung.

Der Halbleiterchip ist vorzugsweise frei von einer den Halbleiterchip umgebenden Umhüllung in dem Gehäuse montiert. Gegenüber einer Gehäuseform, bei der der Halbleiterchip nach der Montage an einem Leiterrahmen mit einem Vergussmaterial umgossen wird, zeichnet sich das Halbleiterbauelement durch eine hohe Alterungsstabilität aus. Die Gefahr einer Verringerung der abgestrahlten Strahlungsleistung aufgrund einer Verfärbung oder Eintrübung der Umhüllung, ist kann so ausgeschlossen werden.

Der Halbleiterchip kann mittels eines Lots am ersten Anschlussleiter befestigt werden. Eine Lotverbindung zeichnet sich durch eine hohe thermische Leitfähigkeit aus. Alternativ kann der Halbleiterchip auch mittels eines Klebemittels am ersten Anschlussleiter befestigt sein. Vorzugsweise ist der Halbleiterchip mittels eines mit elektrisch leitfähigen Partikeln hoch gefüllten Klebemittels befestigt. Unter hoch gefüllt wird in diesem Zusammenhang verstanden, dass das Klebemittel zu einem Gewichtsanteil von mindestens 80 % elektrisch leitfähige Partikel, beispielsweise Metallpartikel, etwa Silberpartikel, enthält.

Das Gehäuse ist vorzugsweise derart ausgebildet, dass der Gehäusekörper auf einer vom Halbleiterchip abgewandten Seite eine Auflagefläche bildet, auf der das Gehäuse bei der Montage auf einem Anschlussträger vollflächig oder zumindest bereichsweise aufliegt.

Weiterhin bevorzugt ist in das Halbleiterbauelement eine elektrische Steuerschaltung für den Halbleiterchip integriert. Insbesondere kann die elektrische Steuerschaltung innerhalb des Gehäuses angeordnet sein. Eine elektrische Steuerschaltung ist beispielsweise in der Druckschrift US 2004/0032888 beschrieben.

Die elektrische Steuerschaltung ist zweckmäßigerweise mit dem Halbleiterchip elektrisch leitend verbunden und weiterhin bevorzugt mittels eines weiteren Anschlussleiters extern elektrisch kontaktierbar.

Die Steuerschaltung ist bevorzugt an einem der Anschlussleiter angeordnet. Insbesondere können die Steuerschaltung und der Halbleiterchip auf dem ersten Anschlussleiter angeordnet sein.

Die vorliegende Erfindung betrifft ein Gehäuse für ein optoelektronisches Halbleiterbauelement gemäß Patentanspruch 1. Besondere Ausführungsformen der Erfindung sind in den abhängigen Patentansprüchen angegeben.

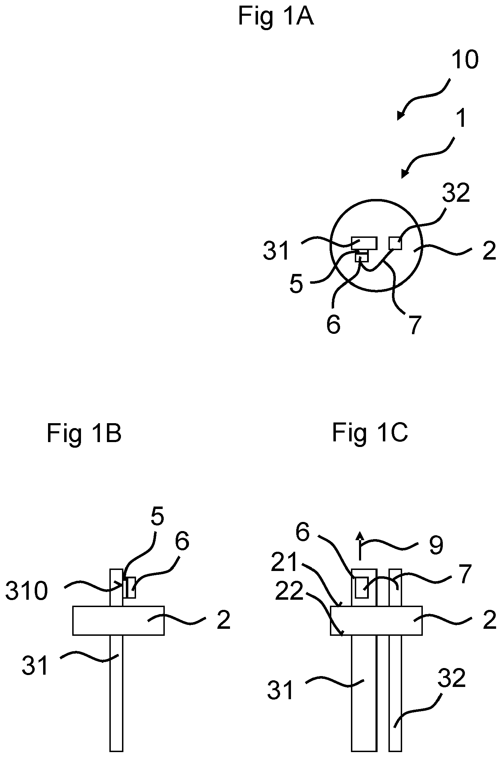

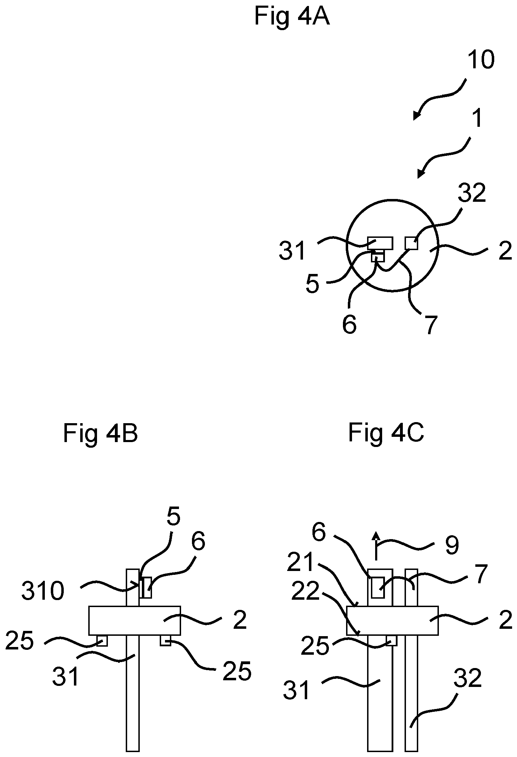

Weitere Merkmale, Ausgestaltungen und Zweckmäßigkeiten der Erfindung ergeben sich aus der folgenden Beschreibung des vierten Ausführungsbeispiels gemäß den Figuren 4A bis 4C sowie der Beschreibung weiterer nicht erfindungsgemäßer Ausführungsbeispiele in Verbindung mit den Figuren 1A bis 1C, 2A bis 2C, 3A und 3B, 5A und 5B und 6.

Es zeigen:
Figuren 1A bis 1C ein erstes nicht erfindungsgemäßes Ausführungsbeispiel für ein Halbleiterbauelement mit einem Gehäuse in schematischer Aufsicht (Figur 1A) und in zwei Seitenansichten aus zueinander senkrechten Richtungen in den Figuren 1B und 1C;
Figuren 2A bis 2C ein zweites nicht erfindungsgemäßes Ausführungsbeispiel für ein Halbleiterbauelement mit einem Gehäuse in schematischer Aufsicht (Figur 2A) und in zwei
Figuren 3A und 3B ein drittes nicht erfindungsgemäßes Ausführungsbeispiel für ein Halbleiterbauelement mit einem Gehäuse anhand von zwei Seitenansichten aus zueinander senkrechten Richtungen;
Figuren 4A bis 4C ein viertes erfindungsgemäßes Ausführungsbeispiel für ein Halbleiterbauelement mit einem Gehäuse in schematischer Aufsicht (Figur 4A) und in zwei Seitenansichten aus zueinander senkrechten Richtungen in den Figuren 4B und 4C;
Figuren 5A und 5B ein fünftes nicht erfindungsgemäßes Ausführungsbeispiel für ein Halbleiterbauelement mit einem Gehäuse anhand von zwei Seitenansichten aus zueinander senkrechten Richtungen; und
Figur 6 ein sechstes nicht erfindungsgemäßes Ausführungsbeispiel für ein Halbleiterbauelement mit einem Gehäuse anhand einer Seitenansicht Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur verbesserten Darstellbarkeit und/oder zum besseren Verständnis übertrieben groß dargestellt sein.

Ein erstes Ausführungsbeispiel für ein Halbleiterbauelement 10 mit einem Gehäuse 1 und einem an dem Gehäuse befestigten Halbleiterchip 6 ist in den Figuren 1A bis 1C schematisch dargestellt. Das Gehäuse 1 weist einen Gehäusekörper 2, einen ersten Anschlussleiter 31 und einen zweiten Anschlussleiter 32 auf. Die Anschlussleiter bilden einen Leiterrahmen für das Gehäuse. Der Gehäusekörper 2 weist eine erste Hauptfläche 21 und eine zweite Hauptfläche 22 auf, zwischen denen sich der Gehäusekörper 2 in vertikaler Richtung erstreckt.

Der erste Anschlussleiter 31 und der zweite Anschlussleiter 32 verlaufen parallel zueinander und durchdringen den Gehäusekörper 2 in vertikaler Richtung, insbesondere senkrecht zu der ersten Hauptfläche. Eine durch die Anschlussleiter aufgespannte Ebene verläuft also senkrecht zur ersten Hauptfläche 21 des Gehäusekörpers. Eine in vertikaler Richtung verlaufende Seitenfläche 310 des ersten Anschlussleiters 31 bildet eine Montagefläche 310, an der der Halbleiterchip 6 an dem vorgefertigten Gehäuse 1 befestigt ist. Der Halbleiterchip 6 ist mittels einer Verbindungsschicht 5 an dem ersten Anschlussleiter 31 befestigt. Für die Verbindungsschicht eignet sich insbesondere ein Lot oder ein elektrisch leitfähiges Klebemittel. Zur Erhöhung der thermischen und elektrischen Leitfähigkeit ist das Klebemittel vorzugsweise als ein mit elektrisch leitfähigen Partikeln hoch gefülltes Klebemittel ausgeführt. Vorzugsweise enthält das Klebemittel zu einem Gewichtsanteil von mindestens 80 % elektrisch leitfähige Partikel.

Der Gehäusekörper 2 ist vorzugsweise als ein Kunststoffkörper ausgebildet, der an die Anschlussleiter 31, 32 angeformt ist. Beispielsweise kann der Gehäusekörper mittels eines Gießverfahrens, etwa durch Gießen, Spritzgießen oder Spritzpressen, hergestellt sein.

Der Kunststoffkörper kann beispielsweise ein Polymermaterial, etwa ein Flüssigkristallpolymermaterial und/oder einen Thermoplast, etwa Polyetheretherketon (PEEK), enthalten oder aus einem solchen Material bestehen.

Der erste Anschlussleiter 31 und der zweite Anschlussleiter 32 können bei der Herstellung aus einem ebenen Metallblech, beispielsweise einem Kupferblech oder einem Blech, das auf einer Kupferlegierung basiert, hergestellt sein. Beispielsweise können der erste Anschlussleiter 31 und der zweite Anschlussleiter 32 mittels Stanzens auf einfache und reproduzierbare Weise ausgebildet werden.

Der zweite Anschlussleiter 32 ist über eine Verbindungsleitung 7, etwa eine Drahtbondverbindung, mit dem Halbleiterchip 6 verbunden. Die seitens der zweiten Hauptfläche 22 aus dem Gehäusekörper 2 herausragenden Bereiche der Anschlussleiter 31, 32 können somit der externen elektrischen Kontaktierung des Halbleiterbauelements 10 dienen. Durch Verbinden der Anschlussleiter mit einer externen Stromquelle können Ladungsträger im Betrieb des Halbleiterbauelements von verschiedenen Seiten in einen zur Erzeugung von Strahlung vorgesehenen aktiven Bereich (nicht explizit dargestellt) des Halbleiterchips 6 injiziert werden und dort unter Emission von Strahlung rekombinieren.

In dem gezeigten Ausführungsbeispiel ist der Halbleiterchip 6 als ein kantenemittierender Halbleiterlaserchip ausgebildet. Eine Hauptabstrahlungsrichtung des Halbleiterchips 6 ist anhand eines Pfeils 9 veranschaulicht.

Die Hauptabstrahlungsrichtung verläuft somit in vertikaler Richtung, also senkrecht zu einer Haupterstreckungsebene des Gehäusekörpers 2.

Ein Querschnitt des ersten Anschlussleiters 31 ist zweckmäßigerweise derart an die Abwärmeleistung des zu montierenden Halbleiterchips 6 angepasst, dass die erzeugte Abwärme effizient aus dem Halbleiterchip abgeführt werden kann.

Vorzugsweise beträgt die Querschnittsfläche mindestens 1 mm². Beispielsweise hat sich gezeigt, dass mit einem Querschnitt des ersten Anschlussleiters 31 von 1 x 2,5 mm² aus einem Kupferblech und einem Lot als Verbindungsschicht ein thermischer Widerstand von 50 K/W oder weniger erzielt werden kann.

Das beschriebene Gehäuse 1 eignet sich somit insbesondere für Halbleiterchips, deren Abwärmeleistung 0,1 W oder mehr beträgt.

Das Gehäuse 1 zeichnet sich weiterhin durch seinen besonders einfachen Aufbau und seine kostengünstige Herstellbarkeit aus. Insbesondere können die Anschlussleiter 31, 32 durch einfaches Strukturieren aus einem in ebener Form vorliegenden Grundmaterial hervorgehen. Durch eine Anordnung der Haupterstreckungsebene der Anschlussleiter 31, 32 senkrecht zu der Haupterstreckungsebene des Gehäusekörpers 2 ist auf einfache Weise ein Gehäuse realisiert, bei dem ein kantenemittierender Laser in einer zur Haupterstreckungsebene des Gehäuses senkrechten Richtung seine Hauptabstrahlungsrichtung aufweist.

Bei der Montage des Halbleiterbauelements kann das Halbleiterbauelements seitens der zweiten Hauptfläche 22 des Gehäusekörpers 2 auf einem Anschlussträger, etwa einer gedruckten Leiterplatte (printed circuit board, PCB), insbesondere vollflächig aufliegen.

In dem gezeigten Ausführungsbeispiel ist der Gehäusekörper 2 in Aufsicht kreisförmig ausgebildet. Je nach Anwendung kann aber auch eine andere Grundfläche Anwendung finden, beispielsweise eine Grundfläche mit einer ovalen Grundform oder einer rechteckigen Grundform.

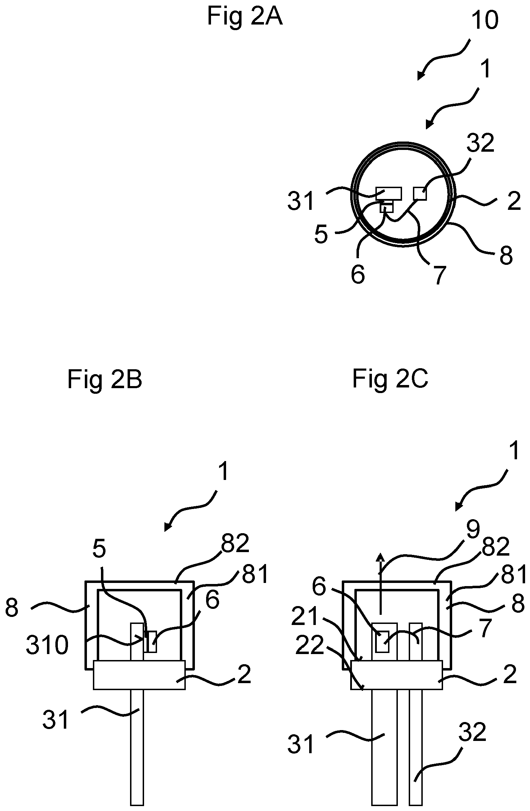

Ein zweites Ausführungsbeispiel für ein Halbleiterbauelement 10 mit einem Gehäuse 1 ist in den Figuren 2A bis 2C schematisch dargestellt. Dieses Ausführungsbeispiel entspricht im Wesentlichen dem im Zusammenhang mit Figur 1 beschriebenen ersten Ausführungsbeispiel.

Im Unterschied hierzu weist das Gehäuse 1 zusätzlich zum Gehäusekörper 2 eine Kappe 8 auf. Die Kappe 8 umfasst einen den Gehäusekörper 2 in lateraler Richtung umlaufenden Mantel 81 und einen parallel zur ersten Hauptfläche 21 des Gehäusekörpers verlaufenden Deckel 82. In diesem Ausführungsbeispiel ist die Kappe mit Mantel und Deckel einstückig ausgebildet.

Zweckmäßigerweise ist die Kappe, insbesondere der Deckel, für die vom Halbleiterchip im Betrieb erzeugte Strahlung, beispielsweise Strahlung im ultravioletten, sichtbaren und/oder infraroten Spektralbereich transparent oder zumindest transluzent ausgebildet. Die Kappe kann beispielsweise einen Kunststoff oder ein Glas enthalten oder aus einem solchen Material bestehen.

Die Kappe 8 dient insbesondere dem Schutz des Halbleiterchips 6 vor äußeren Einflüssen wie mechanischer Belastung, Feuchtigkeit oder Staub.

Eine Umhüllung des Halbleiterchips 6 ist hierfür nicht erforderlich. Die Gefahr einer Degradation der emittierten Leistung aufgrund von Alterungseffekten des Umhüllungsmaterials kann so vermieden werden. Der von der Kappe 8 und dem Gehäusekörper 2, vorzugsweise dicht, umschlossene Innenraum des Gehäuses 1 kann luftgefüllt oder mit einem Schutzgas befüllt sein. Weiterhin kann sich der Innenraum auf normalem Atmosphärendruck, auf einem Unterdruck oder auf einem Überdruck befinden.

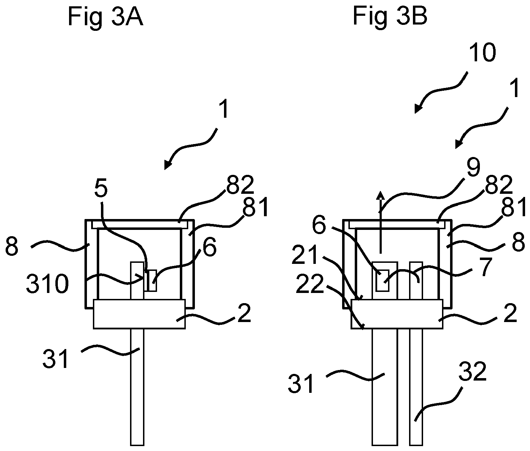

Ein drittes Ausführungsbeispiel für ein Halbleiterbauelement mit einem Gehäuse ist in den Figuren 3A und 3B dargestellt. Dieses dritte Ausführungsbeispiel entspricht im Wesentlichen dem im Zusammenhang mit den Figuren 2A bis 2C dargestellten zweiten Ausführungsbeispiel.

Im Unterschied hierzu sind der Mantel 81 und der Deckel 82 der Kappe 8 als gesonderte Bauteile gefertigt. In diesem Fall kann der Mantel auch aus einem für die vom Halbleiterchip 6 erzeugte Strahlung undurchlässigen Material gefertigt sein. Beispielsweise kann der Mantel ein Metall oder eine metallische Legierung enthalten oder aus einem solchen Material bestehen.

Zur verbesserten Darstellbarkeit ist der Deckel 8 in den Seitenansichten jeweils lediglich in Schnittansicht dargestellt.

Der Deckel 82 ist in den Mantel 81 eingelegt und zweckmäßigerweise mechanisch stabil und dauerhaft mit dem Mantel verbunden.

Je nach Anwendung kann die Kappe 8 an dem Gehäusekörper 2 lösbar, beispielsweise abziehbar, befestigt sein oder, beispielsweise mittels eines Klebemittels, dauerhaft mechanisch stabil mit dem Gehäusekörper 2 verbunden sein.

Ein viertes erfindungsgemäßes Ausführungsbeispiel für ein Halbleiterbauelement ist in den Figuren 4A bis 4C schematisch dargestellt. Dieses vierte Ausführungsbeispiel entspricht im Wesentlichen dem im Zusammenhang mit den Figuren 1A bis 1C beschriebenen ersten Ausführungsbeispiel. Im Unterschied hierzu weist der Gehäusekörper 2 seitens der zweiten Hauptfläche 22 Erhebungen 25 auf. Die Erhebungen sind als Auflagepunkte bei der Montage des Halbleiterbauelements, beispielsweise auf einer gedruckten Leiterplatte, vorgesehen. In Aufsicht auf den Gehäusekörper sind die Erhebungen auf gegenüberliegenden Seiten der Anschlussleiter 31, 32 angeordnet. Die Gefahr eines Verkippens des Halbleiterbauelements ist so vermindert. Von der gezeigten Darstellung abweichend können auch mehr als zwei Erhebungen, beispielsweise drei Erhebungen, zweckmäßig sein. Mittels den Erhebungen ist eine genaue Positionierung des Halbleiterbauelements 10 bei der Montage vereinfacht.

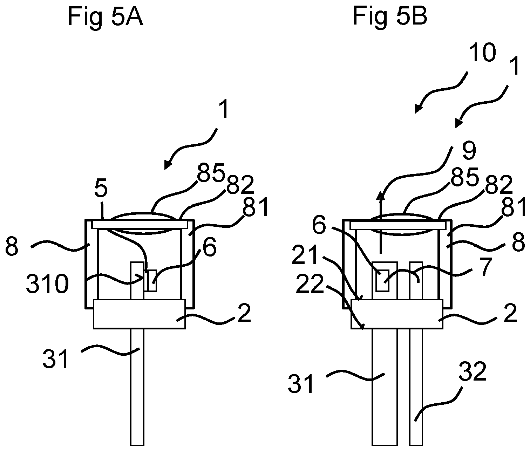

Ein fünftes Ausführungsbeispiel für ein Halbleiterbauelement ist in den Figuren 5A und 5B schematisch dargestellt. Dieses fünfte Ausführungsbeispiel entspricht im Wesentlichen dem im Zusammenhang mit den Figuren 3A und 3B beschriebenen dritten Ausführungsbeispiel. Im Unterschied hierzu weist die Kappe 8 ein optisches Element 85 auf, das in diesem Ausführungsbeispiel exemplarisch als eine Linse ausgeführt ist. Vorzugsweise ist das optische Element zumindest auf einer Seite zumindest entlang einer Raumrichtung konvex gekrümmt. Beispielsweise kann das optische Element als eine konvexe oder eine plankonvexe Linse ausgebildet sein. Auch eine Zylinderlinse kann Anwendung finden. Die im Betrieb vom Halbleiterchip 6 erzeugte Strahlung kann mittels des optischen Elements geformt, insbesondere kollimiert werden. In dem beschriebenen Ausführungsbeispiel ist das optische Element 85 in den Deckel 82 integriert. Davon abweichend kann das optische Element auch bei einer insbesondere wie im Zusammenhang mit den Figuren 2A bis 2C beschriebenen einstückigen Ausgestaltung der Kappe 8 vorgesehen sein.

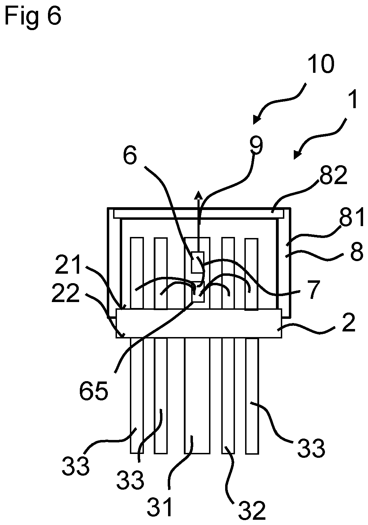

Ein sechstes Ausführungsbeispiel für ein Halbleiterbauelement ist in der Figur 6 schematisch dargestellt. Dieses sechste Ausführungsbeispiel entspricht im Wesentlichen dem im Zusammenhang mit den Figuren 3A und 3B beschriebenen dritten Ausführungsbeispiel. Im Unterschied hierzu weist das Gehäuse 1 zusätzlich zu dem ersten Anschlussleiter 31 und dem zweiten Anschlussleiter 32 drei weitere Anschlussleiter 33 auf. Die weiteren Anschlussleiter 33 sind für die elektrische Kontaktierung einer elektrischen Steuerschaltung 65 vorgesehen. Die elektrische Steuerschaltung ist vorzugsweise als ein integrierter Schaltkreis ausgestaltet. Die Steuerschaltung ist direkt mit dem Halbleiterchip 6 verbunden, beispielsweise mittels einer Verbindungsleitung 7. Aufgrund der Integration der Steuerschaltung im Inneren des Gehäuses 1 und der damit verbundenen kurzen elektrischen Verbindungsleitungen wird die Erzeugung von sehr kurzen Pulsen vereinfacht. Weiterhin kann in dem Gehäuse zumindest ein Kondensator angeordnet werden.

In dem gezeigten Ausführungsbeispiel sind der Halbleiterchip 6 und die elektrische Steuerschaltung 65 an dem ersten Anschlussleiter 31 befestigt. Aufgrund des größeren Querschnitts des ersten Anschussleiters ist eine Montage der Steuerschaltung so vereinfacht. Die Steuerschaltung kann aber auch an einem der anderen Anschlussleiter befestigt sein.

Die weiteren Anschlussleiter 33 können beispielsweise jeweils für eine Versorgungsspannung der elektrischen Steuerschaltung, für einen Massekontakt oder als ein TriggerEingang vorgesehen sein.

Selbstverständlich kann eine solche elektrische Steuerschaltung auch bei den weiteren vorstehend beschriebenen Ausführungsbeispielen des Halbleiterbauelements, insbesondere unabhängig von der konkreten Ausgestaltung der Kappe 8, Anwendung finden.

Die beschriebene Bauform des Gehäuses 1 zeichnet sich durch eine besonders hohe Flexibilität im Hinblick auf die konkrete Ausgestaltung aus. Insbesondere kann die Anzahl der Anschlussleiter bei der Herstellung auf einfache Weise variiert werden.

## Patentansprüche

1. Gehäuse (1) für ein optoelektronisches Halbleiterbauelement (10), bei dem das Gehäuse (1) einen Gehäusekörper (2), einen ersten Anschlussleiter (31) und einen zweiten Anschlussleiter (32) aufweist, wobei sich der erste Anschlussleiter (31) und der zweite Anschlussleiter (32) in einer vertikalen Richtung jeweils durch den Gehäusekörper (2) hindurch erstrecken, und ein Halbleiterchip (6) an dem ersten Anschlussleiter (31) befestigt ist, **dadurch gekennzeichnet dass**,
der erste Anschlussleiter einen Querschnitt von mindestens 1 mm² aufweist,
und
sich der Gehäusekörper (2) in einer vertikalen Richtung zwischen einer ersten Hauptfläche (21) und einer zweiten Hauptfläche (22) erstreckt, wobei der Gehäusekörper (2) seitens der zweiten Hauptfläche Erhebungen (25) aufweist, die als Auflagepunkte bei der Montage des Halbleiterbauelements (10) vorgesehen sind.

2. Gehäuse nach Anspruch 1,
bei dem der Gehäusekörper ein Kunststoffkörper ist, der an den ersten Anschlussleiter und an den zweiten Anschlussleiter angeformt ist.

3. Gehäuse nach Anspruch 1 oder 2,
bei dem der erste Anschlussleiter und der zweite Anschlussleiter in einer zur vertikalen Richtung senkrecht verlaufenden lateralen Richtung voneinander beabstandet sind und in einer Ebene verlaufen, die durch die vertikale Richtung und durch die laterale Richtung aufgespannt wird.

4. Gehäuse nach einem der Ansprüche 1 bis 3,
bei dem eine entlang der vertikalen Richtung verlaufende Seitenfläche des ersten Anschlussleiters als eine Montagefläche (310) für einen Halbleiterchip vorgesehen ist.

5. Gehäuse nach einem der Ansprüche 1 bis 4,
bei dem der erste Anschlussleiter an jeder Stelle entlang der vertikalen Richtung einen größeren Querschnitt aufweist als der zweite Anschlussleiter.

6. Gehäuse nach einem der Ansprüche 1 bis 5,
bei dem das Gehäuse eine Kappe (8) aufweist, die den ersten Anschlussleiter und den zweiten Anschlussleiter auf einer Seite des Gehäusekörpers umgibt.

7. Gehäuse nach Anspruch 6,
bei dem die Kappe auf den Gehäusekörper steckbar ausgebildet ist.

8. Gehäuse nach Anspruch 6 oder 7,
bei dem die Kappe einstückig ausgebildet ist und für Strahlung im ultravioletten, sichtbaren und/oder infraroten Spektralbereich durchlässig ist.

9. Gehäuse nach Anspruch 6 oder 7,
bei dem die Kappe einen Deckel (82) und einen den Deckel umlaufenden Mantel (81) aufweist, wobei der Deckel für Strahlung im ultravioletten, sichtbaren und/oder infraroten Spektralbereich durchlässig ist und der Mantel ein Metall enthält.

10. Halbleiterbauelement nach Anspruch 1,
bei dem der Halbleiterchip eine Hauptabstrahlungsrichtung aufweist, die entlang der vertikalen Richtung verläuft.

11. Halbeiterbauelement nach Anspruch 1 oder 10,
bei dem der Halbleiterchip frei von einer den Halbleiterchip umgebenden Umhüllung in dem Gehäuse montiert ist.

12. Halbleiterbauelement nach einem der Ansprüche 1 oder 10 bis 11,
bei dem der Halbleiterchip mittels eines Lots oder mittels eines mit elektrisch leitfähigen Partikeln hochgefüllten Klebemittels am ersten Anschlussleiter befestigt ist.

13. Halbleiterbauelement nach einem der Ansprüche 1 oder 10 bis 12,
bei dem eine elektrische Steuerschaltung (65) für den Halbleiterchip innerhalb des Gehäuses angeordnet ist.

## Claims

1. A package (1) for an optoelectronic semiconductor component (10), in which the package (1) comprises a package body (2), a first connecting lead (31) and a second connecting lead (32), wherein the first connecting lead (31) and the second connecting lead (32) in each case extend in a vertical direction through the package body (2),and a semiconductor chip (6) is fastened to the first connecting lead (31), **characterized in that**, the first connecting (31) lead has a cross-section of at least 1 mm² and
the package body (2) extends in a vertical direction between a first major surface (21) and a second major surface (22), the package body (2) having, on the side of the second major surface, raised portions (25) which are provided as bearing points during mounting the semiconductor component (10).

2. A package according to claim 1,
in which the package body is a plastics body which is moulded onto the first connecting lead and the second connecting lead.

3. A package according to claim 1 or 2,
in which the first connecting lead and the second connecting lead are spaced apart from one another in a lateral direction extending perpendicularly to the vertical direction and extend in a plane spanned by the vertical direction and by the lateral direction.

4. A package according to any one of claims 1 to 3,
in which a side face of the first connecting lead extending along the vertical direction is provided as a mounting face (310) for a semiconductor chip.

5. A package according to any one of claims 1 to 4,
in which the first connecting lead has a larger cross-section than the second connecting lead at any point along the vertical direction.

6. A package according to any one of claims 1 to 5,
in which the package comprises a cap (8) which surrounds the first connecting lead and the second connecting lead on one side of the package body.

7. A package according to claim 6,
in which the cap is constructed such that it may be pushed onto the package body.

8. A package according to claim 6 or claim 7,
in which the cap is of one-piece construction and transmissive to radiation in the ultraviolet, visible and/or infrared spectral range.

9. A package according to claim 6 or claim 7,
in which the cap comprises a lid (82) and a jacket (81) surrounding the lid, the lid being transmissive to radiation in the ultraviolet, visible and/or infrared spectral range and the jacket containing a metal.

10. A semiconductor component according to claim 1,
in which the semiconductor chip comprises a main emission direction which extends along the vertical direction.

11. A semiconductor component according to claim 1 or 10,
in which the semiconductor chip is mounted in the package without an enclosure surrounding the semiconductor chip.

12. A semiconductor component according to claim 1 or any one of claims 10 to 11,
in which the semiconductor chip is fastened to the first connecting lead by means of a solder or by means of an adhesive with an elevated content of conductive filler particles.

13. A semiconductor component according to any one of claims 1 or 10 to 12,
in which an electrical control circuit (65) for the semiconductor chip is arranged within the package.

## Revendications

1. Boîtier (1) pour un composant semi-conducteur optoélectronique (10), le boîtier (1) comprenant un corps de boîtier (2), un premier conducteur de raccordement (31) et un second conducteur de raccordement (32), le premier conducteur de raccordement (31) et le second conducteur de raccordement (32) s'étendant chacun verticalement à travers le corps de boîtier (2), et une puce semi-conductrice (6) étant fixée au premier conducteur de raccordement (31), **caractérisé en ce que**
le premier conducteur de raccordement présente une section transversale d'au moins 1 mm²,
et
le corps de boîtier (2) s'étend verticalement entre une première surface principale (21) et une deuxième surface principale (22), le corps de boîtier (2) présentant, du côté de la deuxième surface principale, des élévations (25) prévues comme points d'appui lors du montage du composant semi-conducteur (10).

2. Boîtier selon la revendication 1,
le corps du boîtier étant un corps en plastique moulé sur le premier conducteur de raccordement et le second conducteur de raccordement.

3. Boîtier selon la revendication 1 ou 2,
le premier conducteur de raccordement et le second conducteur de raccordement étant espacés l'un de l'autre dans une direction latérale perpendiculaire à la verticale et s'étendant dans un plan couvert par la direction verticale et la direction latérale.

4. Boîtier selon l'une des revendications 1 à 3,
sur lequel une surface latérale du premier conducteur de raccordement s'étendant à la verticale est prévue comme surface de montage (310) pour une puce semi-conductrice.

5. Boîtier selon l'une des revendications 1 à 4,
sur lequel le premier conducteur de raccordement présente en tout point de la direction verticale une section transversale supérieure à celle du second conducteur de raccordement.

6. Boîtier selon l'une des revendications 1 à 5,
le boîtier étant muni d'un capuchon (8) entourant le premier conducteur de raccordement et le second conducteur de raccordement sur un côté du corps du boîtier.

7. Boîtier selon la revendication 6,
sur lequel le capuchon est conçu pour être enfiché sur le corps du boîtier.

8. Boîtier selon la revendication 6 ou 7,
sur lequel le capuchon est formé d'une seule pièce et est perméable aux rayonnements dans le domaine spectral ultraviolet, visible et/ou infrarouge.

9. Boîtier selon la revendication 6 ou 7,
sur lequel le capuchon comprend un couvercle (82) et une gaine (81) entourant le couvercle, le couvercle étant perméable aux rayonnements dans le domaine spectral ultraviolet, visible et/ou infrarouge et la gaine contenant un métal.

10. Composant semi-conducteur selon la revendication 1,
dans lequel la puce semi-conductrice présente une direction principale de rayonnement dans le sens vertical.

11. Composant semi-conducteur selon la revendication 1 ou 10,
dans lequel la puce semi-conductrice est installée dans le boîtier sans enveloppe entourant la puce semi-conductrice.

12. Composant semi-conducteur selon l'une des revendications 1 ou 10 à 11,
dans lequel la puce semi-conductrice est fixée au premier conducteur de raccordement au moyen d'une soudure ou d'un adhésif fortement chargé de particules électro-conductrices.

13. Composant semi-conducteur selon l'une des revendications 1 ou 10 à 12,
dans lequel un circuit de commande électrique (65) pour la puce semi-conductrice est disposé à l'intérieur du boîtier.
